# DEMANDE DE BREVET EUROPEEN

(11) **EP 0 780 932 A1**
(43) Date de publication de la demande: **25.06.1997**
(21) Numéro de dépôt: 96402647.0
(22) Date de dépôt: 06.12.1996
(51) Int. Cl.: H01R 23/70, H05K 7/14

(54) **Dispositif de connexion de modules électroniques**

(30) Priorité: 19.12.1995 FR 9515045
(71) Demandeur: VIBRACHOC, 75000 Paris (FR)
(72) Inventeur: Pavie, Denis, 91820 Boutigny sur Essonne (FR)
(74) Mandataire: Hurwic, Aleksander

(57) **Abrégé**

La présente invention se rapporte principalement à un dispositif de connexion de modules électroniques présentant une grande sécurité contre des déconnexions accidentelles dans des conditions sévères.

Un dispositif selon l'invention comporte un connecteur proprement dit (27) à insertion par translation du module par rapport à un dispositif de réception, notamment par rapport à un bâti, un élément d'ancrage (7) solidarisé avec le module ou avec le dispositif de réception, un dispositif d'accrochage (11, 15) sur l'élément d'ancrage (7) solidarisé avec le dispositif de réception ou avec le module et comportant un levier (17) dont la rotation après accrochage sur l'élément d'ancrage assure le positionnement et la translation du module avec insertion du connecteur (27), l'établissement des connexions électriques ainsi que la solidarisation du module avec le dispositif de réception.

La présente invention s'applique notamment à l'industrie informatique et électronique.

La présente invention s'applique principalement à la réalisation d'équipements électroniques et informatiques fonctionnant en temps réel pour environnement sévère.

## Description

La présente invention se rapporte principalement à un dispositif de connexion de modules électroniques présentant une grande sécurité contre des déconnexions accidentelles dans des conditions sévères d'utilisation.

Les équipements électroniques se composent souvent d'un dispositif d'interconnexion de type "fond de panier", bâti (*rack* en terminologie anglo-saxonne) ou carte mère recevant des modules électroniques sous forme de cartes électroniques ou de châssis électroniques amovibles. La construction modulaire de ces équipements permet de choisir les modules à mettre en oeuvre nécessaires à l'accomplissement des tâches assignées à l'équipement. Des fonctions supplémentaires peuvent être rajoutées au cours de l'exploitation de l'équipement. De même, les modules non utilisés peuvent être retirés pour leur réutilisation sur un équipement différent, pour diminuer la consommation électrique ou la masse de l'équipement, pour éviter les incompatibilités avec des nouveaux modules et/ou pour libérer un emplacement de connexion pour un module plus performant. La maintenance d'équipements électroniques modulaires est plus rapide et moins coûteuse dans la mesure où l'on peut vérifier le bon fonctionnement de chaque module pour ne remplacer que le ou les module(s) défectueux. Les modules comportant des éléments rayonnants des ondes électromagnétiques risquant de compromettre le bon fonctionnement des autres éléments de l'équipement électronique ainsi que les modules comportant des éléments très sensibles au rayonnement électromagnétique sont habituellement munis d'un blindage.

Toutefois, la construction d'équipements électroniques modulaires imposent la mise en oeuvre des connecteurs, ce qui présente de nombreux inconvénients. La fiabilité de la connexion est souvent insuffisante pour permettre le fonctionnement correct de l'équipement lorsqu'il est soumis à des contraintes sévères, notamment à des vibrations ou à des chocs, risquant de compromettre la fixation des modules sur le dispositif d'interconnexion ou tout au moins de provoquer des micro-coupures dans les liaisons électriques. Ces micro-coupures peuvent perturber le fonctionnement de l'équipement électronique, ce qui est particulièrement gênant dans le cas des équipements d'acquisition de données, de systèmes de supervision, de commande ou de contrôle en temps réel.

C'est par conséquent un but de la présente invention d'offrir un dispositif particulièrement sûr de connexion de modules électriques et/ou électroniques.

C'est également un but de la présente invention d'offrir un dispositif garantissant une connexion non perturbée lorsqu'il est soumis à un environnement sévère.

C'est aussi un but de la présente invention d'offrir un dispositif permettant une connexion rapide des modules électriques et/ou électroniques.

C'est également un but de la présente invention d'offrir un dispositif permettant une déconnexion et une libération rapide des modules électriques et/ou électroniques.

C'est aussi un but de la présente invention d'offrir un dispositif permettant de nombreuses connexions et déconnexions sans perte de performance ni de fiabilité.

C'est également un but de la présente invention d'offrir un dispositif empêchant une connexion incorrecte ou incomplète des modules électriques et/ou électroniques.

C'est aussi un but de la présente invention d'offrir un dispositif permettant une bonne accessibilité et une bonne visibilité des modules connectés.

C'est également un but de la présente invention d'offrir un dispositif de connexion présentant un faible encombrement et une faible masse.

C'est aussi un but de la présente invention d'offrir un dispositif de connexion ayant un coût de revient modéré.

Ces buts sont atteints par un dispositif selon l'invention comportant un connecteur proprement dit à insertion par translation du module par rapport à un dispositif de réception, notamment par rapport à un bâti, un élément d'ancrage solidarisé avec le module ou avec le dispositif de réception, un dispositif d'accrochage sur l'élément d'ancrage solidarisé avec le dispositif de réception ou avec le module et comportant un levier dont la rotation après accrochage sur l'élément d'ancrage assure le positionnement et la translation du module avec insertion du connecteur, l'établissement des connexions électriques ainsi que la solidarisation du module avec le dispositif de réception.

Avantageusement, l'accrochage du dispositif d'accrochage sur l'élément d'ancrage garantit, après la rotation du levier, une connexion et une solidarisation correctes entre le module et le dispositif de réception.

Avantageusement, un positionnement incorrect du module par rapport au dispositif de réception ne permet pas l'accrochage du dispositif d'accrochage sur l'élément d'ancrage et empêche ainsi une connexion ou une solidarisation incorrecte.

Avantageusement, le dispositif selon l'invention comporte des moyens de verrouillage du levier monté à rotation dans la position correspondant à la connexion et à la solidarisation du module et du dispositif de réception.

L'invention a principalement pour objet un dispositif de connexion et de solidarisation d'un premier élément sur un second élément, l'un des éléments étant un module électrique ou électronique, l'autre élément étant un dispositif de réception du module électrique ou électronique, le dispositif comportant un connecteur à insertion par translation relative des deux éléments, caractérisé en ce qu'il comporte :
a) solidarisés avec le premier élément, des moyens d'ancrage ;
b) solidarisés avec le second élément, des moyens d'accrochage sur les moyens d'ancrage comprenant un levier dont la rotation après accrochage des moyens d'accrochage sur les moyens d'ancrage assure le positionnement et la translation du second élément par rapport au premier élément, avec insertion du connecteur, établissement des connexions électriques ainsi que la solidarisation des deux éléments.

L'invention a également pour objet un dispositif, caractérisé en ce que le premier élément est un bâti et en ce que le second élément est un châssis électrique et/ou électronique.

L'invention a également pour objet un dispositif, caractérisé en ce que les moyens d'ancrage sont disposés sur le premier élément de manière à empêcher l'accrochage des moyens d'accrochage sur les moyens d'ancrage dans le cas où la position relative desdits premiers et seconds éléments ne permet pas de garantir lors de la rotation du levier une solidarisation et une connexion correctes et sûres.

L'invention a également pour objet un dispositif, caractérisé en ce qu'il comporte des moyens de verrouillage desdits premiers et seconds éléments dans la condition connectée comprenant des moyens pour empêcher la rotation non désirée du levier.

L'invention a également pour objet un dispositif, caractérisé en ce que les moyens de verrouillage comportent un taquet solidarisé avec le levier et un crochet de verrouillage solidarisé avec le premier élément, et en ce que, en fin de course de connexion, le taquet s'accroche automatiquement sur le crochet.

L'invention a également pour objet un dispositif, caractérisé en ce qu'il comporte un ressort de rappel du taquet vers la condition accrochée sur le crochet de verrouillage ainsi qu'un bouton de commande monté en translation sur le levier, prenant appui sur le taquet, la translation du bouton entraînant le taquet, assurant sa libération et par suite le déverrouillage du dispositif.

L'invention a également pour objet un dispositif, caractérisé en ce que la distance entre un axe de rotation du levier et une extrémité de manoeuvre de ce levier est grande par rapport à la distance entre la surface d'appui des moyens d'accrochage sur les moyens d'ancrage et ledit axe de rotation.

L'invention a également pour objet un dispositif, caractérisé en ce que le levier ménage un accès au centre de la face avant d'un châssis électronique.

L'invention a également pour objet un dispositif, caractérisé en ce que les moyens d'ancrage comportent une tige montée sur une fourchette comportant une fente et en ce que les moyens d'accrochage comportent un crochet passant dans la fente et prenant appui sur la tige.

L'invention a également pour objet un dispositif, caractérisé en ce que les moyens d'ancrage comportent un ressort exerçant sur la fourchette une force de rappel vers le premier élément.

L'invention a également pour objet un dispositif, caractérisé en ce que la distance d entre un point situé sur la face des moyens d'accrochage dirigée, en position d'insertion, vers l'intérieur du logement et le point de la surface d'appui des moyens d'accrochage sur les moyens d'ancrage disposés en vis-à-vis, est supérieure à la course d' d'insertion et de connexion du connecteur du bâti avec le connecteur du module électronique.

L'invention a également pour objet un dispositif, caractérisé en ce que les moyens d'accrochage comportent un talon arrière définissant, avec la surface d'appui des moyens d'accrochage, une rainure de réception des moyens d'ancrage.

L'invention a également pour objet un dispositif, caractérisé en ce qu'il comporte des moyens de codage adaptés sur les modules électroniques à insérer et sur les logements de réception des modules électroniques correspondants, propres à chaque ensemble module électronique à insérer -logement de réception susceptible de les recevoir.

L'invention sera mieux comprise au moyen de la description ci-après et des figures annexées données comme des exemples non limitatifs et sur lesquels :
- la figure 1 est une vue de face d'un bâti selon la présente invention ;
- la figure 2 comporte trois vues en coupe longitudinale illustrant la connexion d'un module selon la présente invention ;
- la figure 3 comporte une vue en coupe longitudinale et une vue de face, à plus grande échelle, d'un module connecté dans un bâti selon l'invention ;
- la figure 4a est une vue de côté des éléments destinés à être liés à un module, en condition ouverte avant connexion ;
- la figure 4b est une vue analogue en condition fermée ;
- la figure 4c est une vue de face des éléments de la figure 4a ;
- la figure 5a est une vue de face d'une plaque mise en oeuvre dans le dispositif selon la présente invention ;
- la figure 5b est une vue de côté de la plaque de la figure 5a ;
- la figure 5c est une vue de dessus de la plaque de la figure 5a;
- la figure 6a est une vue de côté d'un élément d'un levier mis en oeuvre dans le dispositif selon la présente invention ;
- la figure 6b est une vue de face de l'élément de levier de la figure 6a ;
- la figure 7 est une vue de côté d'un élément d'accrochage du levier du dispositif selon la présente invention ;
- la figure 8a est une vue de dessus d'un étrier portant un élément d'ancrage solidarisé avec le bâti selon la présente invention ;
- la figure 8b est une vue de face de l'étrier de la figure 8a ;
- la figure 8c est une vue de côté de l'étrier de la figure 8a recevant l'élément d'accrochage de la figure 7 ;
- la figure 9a est une vue de côté d'une des chapes permettant le montage à rotation du levier de la figure 6 sur la plaque de la figure 5 ;
- la figure 9b est une vue de face de la chape de la figure 9a ;
- la figure 10a est une vue de côté d'un crochet d'un dispositif de verrouillage dans la condition connectée du levier ;
- la figure 10b est une vue de face du crochet de la figure 10a ;
- la figure 10c est une vue de dessus du crochet de la figure 10a ;
- la figure 11a est une vue de côté d'un taquet d'accrochage sur le crochet de la figure 10 ;
- la figure 11b est une vue de face du taquet de la figure 11a dans la condition verrouillée ;
- la figure 11c est une vue de face du taquet de la figure 11a dans la condition déverrouillée ;
- la figure 12a est une vue de côté d'un bouton poussoir de déverrouillage du levier de la figure 6 ;
- la figure 12b est une vue de face du bouton poussoir de la figure 12a ;
- la figure 12c est une vue de dessus du bouton poussoir de la figure 12a ;
- la figure 13a est une vue de côté d'un ressort de rappel vers la condition verrouillée du taquet de la figure 11 ;
- la figure 13b est une vue de face du ressort de la figure 13a ;
- la figure 14 comporte cinq vues de côté d'une variante de réalisation du dispositif selon l'invention.

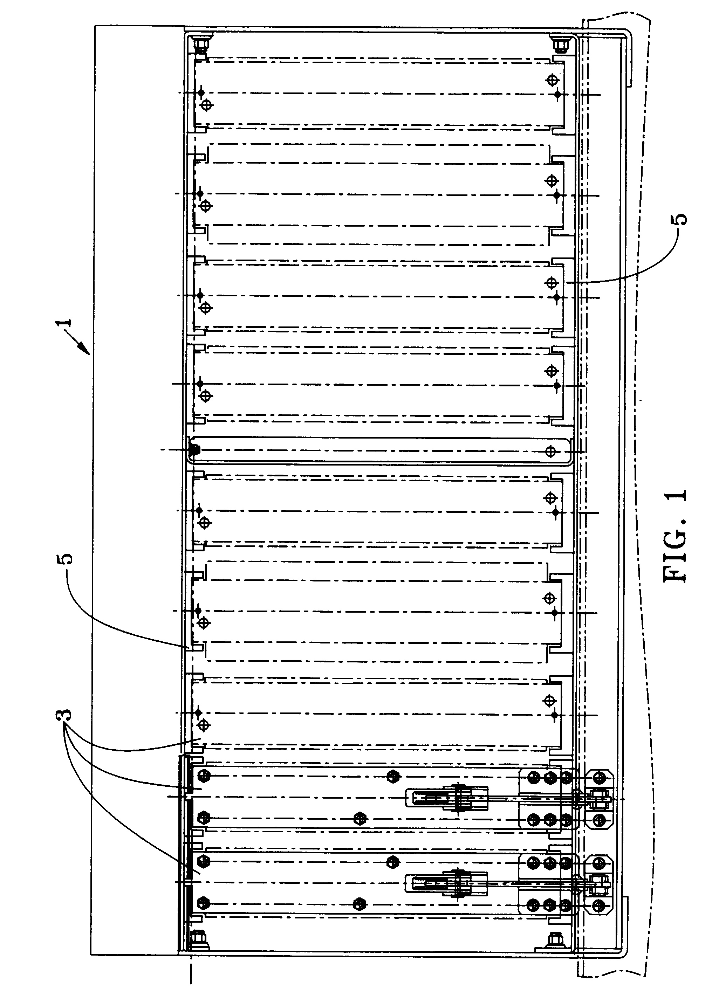

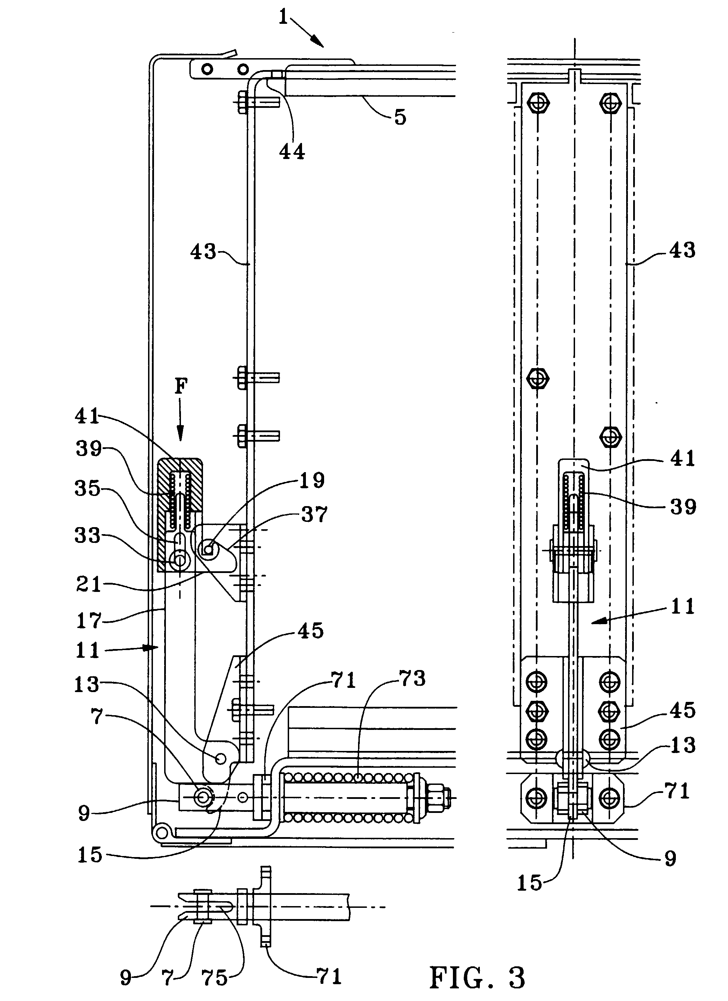

Sur les figures 1 à 14, on a utilisé les mêmes références pour désigner les mêmes éléments.

Sur la figure 1, on peut voir un bâti 1 susceptible de recevoir en face avant neuf modules électroniques amovibles 3, par exemple des châssis électroniques ayant une géométrie adaptée à celle du bâti. Le bâti 1 comporte des moyens de guidage des châssis électroniques 3 lors de leur insertion. Dans l'exemple illustré, les faces supérieure et inférieure du bâti 1 sont munies de rails 5 en U disposés en vis-à-vis et assurant le guidage des châssis électroniques 3 lors de leur insertion dans le bâti. La connexion de deux premiers châssis en partant de la gauche sur la figure 1 est assurée par un dispositif de connexion selon la présente invention comportant, solidarisée avec le bâti 1, une tige 7 montée sur un étrier 9 formant les moyens d'ancrage et, solidarisée avec un châssis électronique 3, une pièce 11 montée à rotation autour d'un axe 13, comprenant à une première extrémité un crochet 15 d'accrochage sur la tige 7 et, à une extrémité opposée, un levier 17 de manoeuvre du crochet 15.

Avantageusement, la longueur du levier 17, c'est-à-dire la distance entre l'axe de rotation 13 et l'extrémité du levier, est grande par rapport à la taille du crochet 15, c'est-à-dire la distance entre la surface d'appui du crochet 15 sur la tige 7 et l'axe de rotation 13, de manière à permettre une manoeuvre aisée du dispositif selon la présente invention et un maintien ferme du châssis 3. Le rapport entre la longueur du levier 17 et la taille du crochet 15 est par exemple égal à 16 mais pouvant varier selon l'application et l'effet recherché. Avantageusement, le dispositif comporte des moyens de verrouillage en condition connectée et solidarisée. Dans l'exemple préféré de réalisation, les moyens de verrouillage comportent, situé à proximité de l'extrémité du levier 17, un crochet 19 solidarisé avec le châssis électronique 3 et un taquet 21 monté sur le levier 17 venant s'accrocher sur le crochet 19. Des moyens, par exemple un ressort, empêchent un désengagement accidentel du crochet 19 et du taquet 21. Le déverrouillage est obtenu par un appui sur l'extrémité du levier 17 selon la flèche F assurant la libération du taquet 21, et par suite celle du levier 17.

Nous allons maintenant expliquer le fonctionnement du dispositif selon la présente invention.

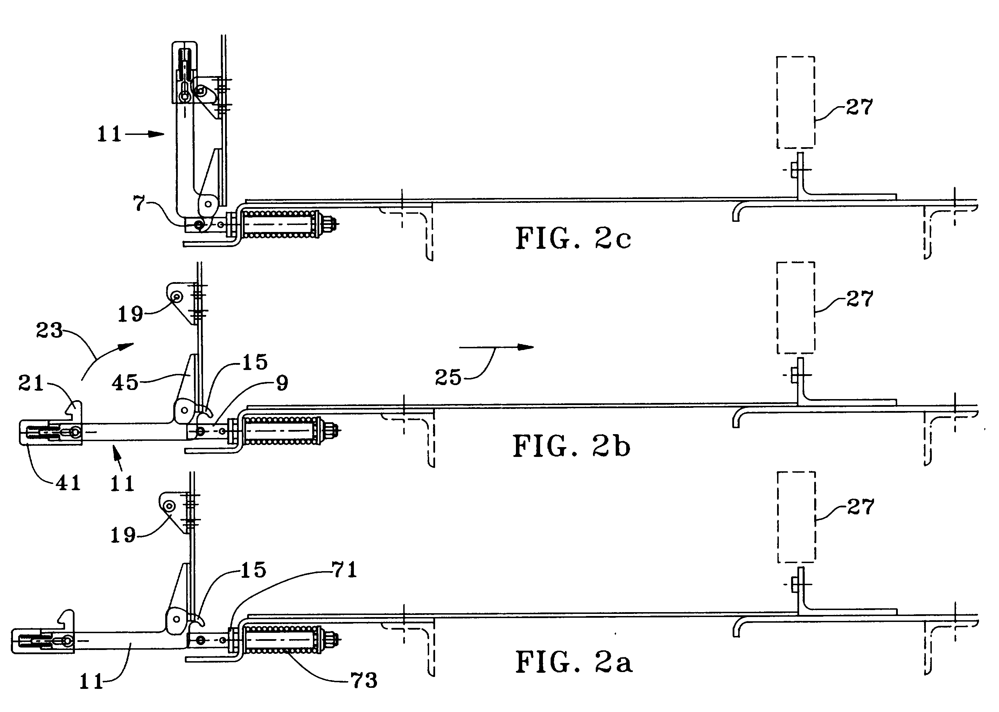

Sur la figure 2a, un châssis électronique 3 en cours de mise en place dans un bâti 1 n'a pas encore atteint une position permettant sa connexion et sa solidarisation. Dans un tel cas, la rotation du levier 17 ne permet pas l'accrochage du crochet 15 sur la tige 7. Si un opérateur tente d'effectuer une connexion dans la position illustrée sur la figure 2a, ce qui correspond à une fausse manoeuvre, il en sera immédiatement averti par l'impossibilité d'accrocher le crochet 15 sur la tige 7. Au contraire, sur la figure 2b, on peut voir le châssis électronique 3 dans la position correcte permettant par la rotation de 90° du levier 17 selon la flèche 23, vers la paroi du châssis 3, d'assurer l'accrochage du crochet 17 sur la tige 7 et par suite la translation du châssis 3 selon la flèche 25 avec connexion du connecteur du châssis (non représenté) sur un connecteur 27 du bâti 1.

Sur un premier exemple de réalisation du dispositif selon la présente invention, le levier 17 est disposé sensiblement dans le plan médian du châssis électronique 3.

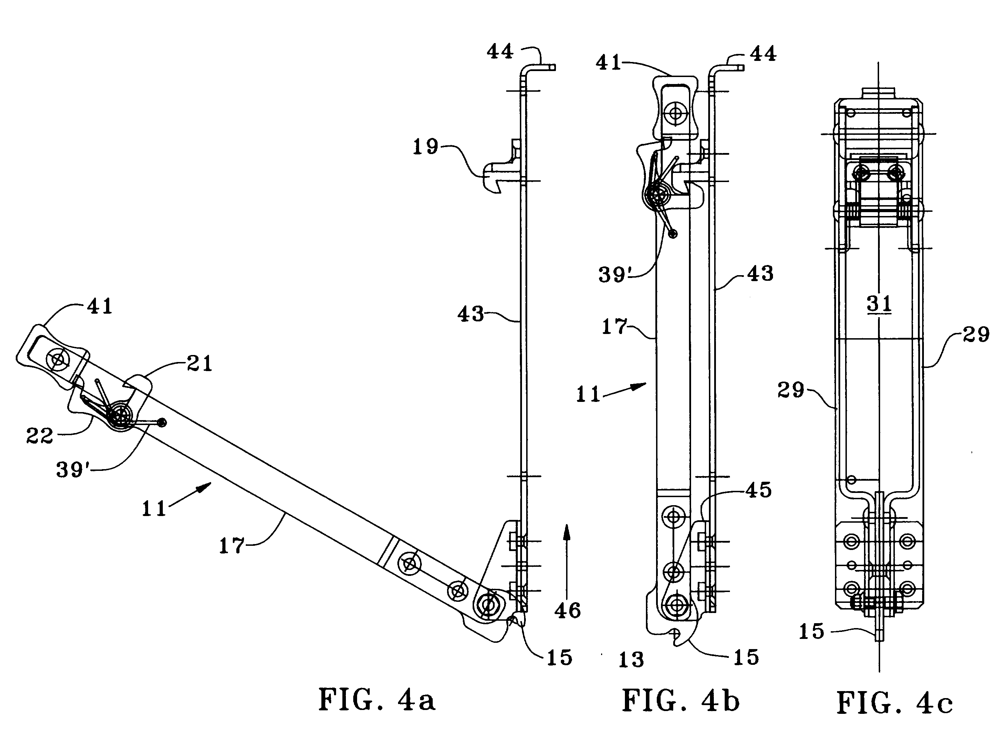

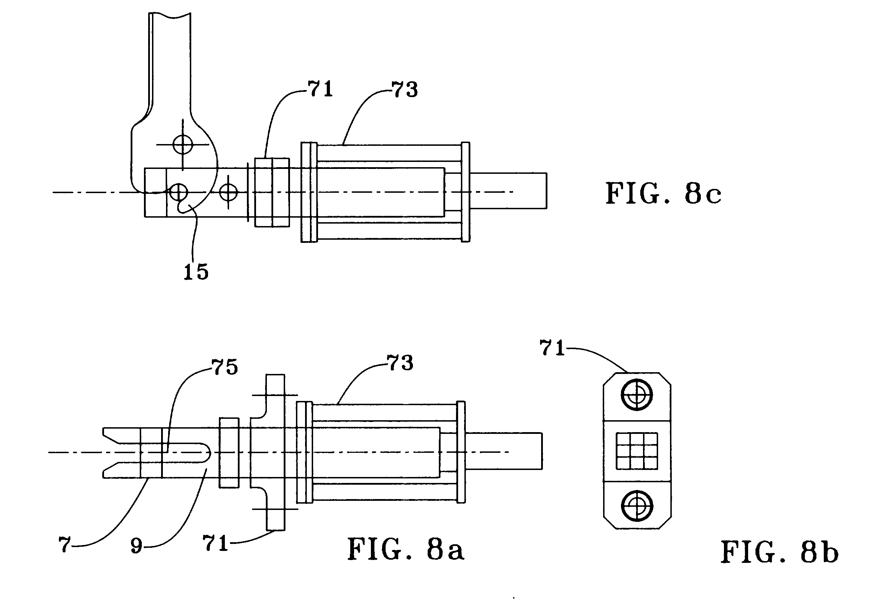

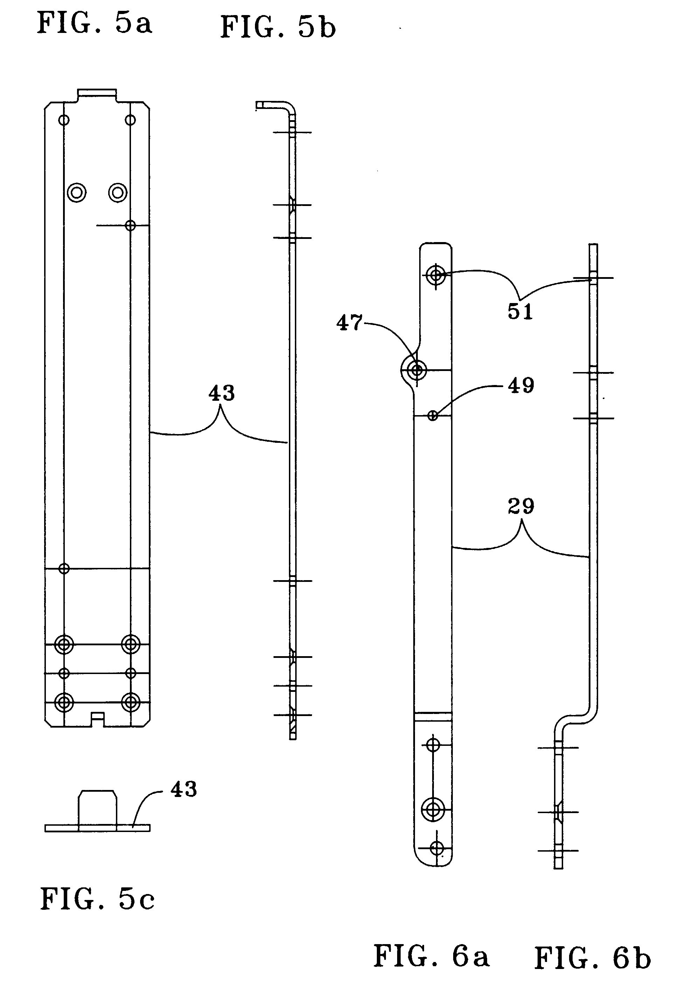

Cette disposition peut s'avérer gênante si la partie médiane inférieure du châssis électronique 3 porte des afficheurs ou des connecteurs. L'exemple de réalisation illustré sur les figures 4 et 6 comportent un levier 17 comportant deux branches 29 s'écartant symétriquement par rapport à l'axe médian de la face avant du châssis électronique 3, de manière à dégager un accès 31 susceptible de porter des afficheurs, des récepteurs ou des émetteurs de signaux de télécommande ou des connecteurs.

Dans l'exemple illustré sur les figures 1 à 3, le crochet 19 de verrouillage est constitué par une simple tige alors que le taquet 21 est une pièce guidée en translation sur le levier 17 par une tige 33 disposée dans une encoche longitudinale 35. La partie avant du taquet 21 est munie d'une rampe 37 repoussant le taquet 21 selon la flèche F jusqu'à l'obtention du verrouillage. Une force de rappel de sens opposé à celui de la flèche F est exercée sur le taquet 21 par un ressort à boudin 39 prenant appui, d'une part, sur le levier 17 et, d'autre part, sur un bouton de commande 41.

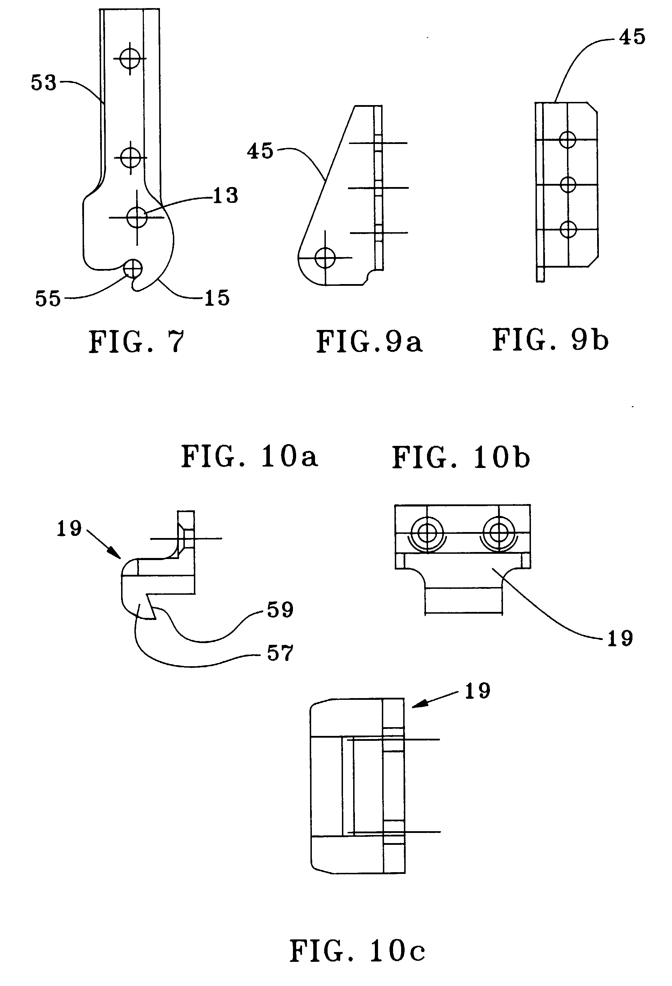

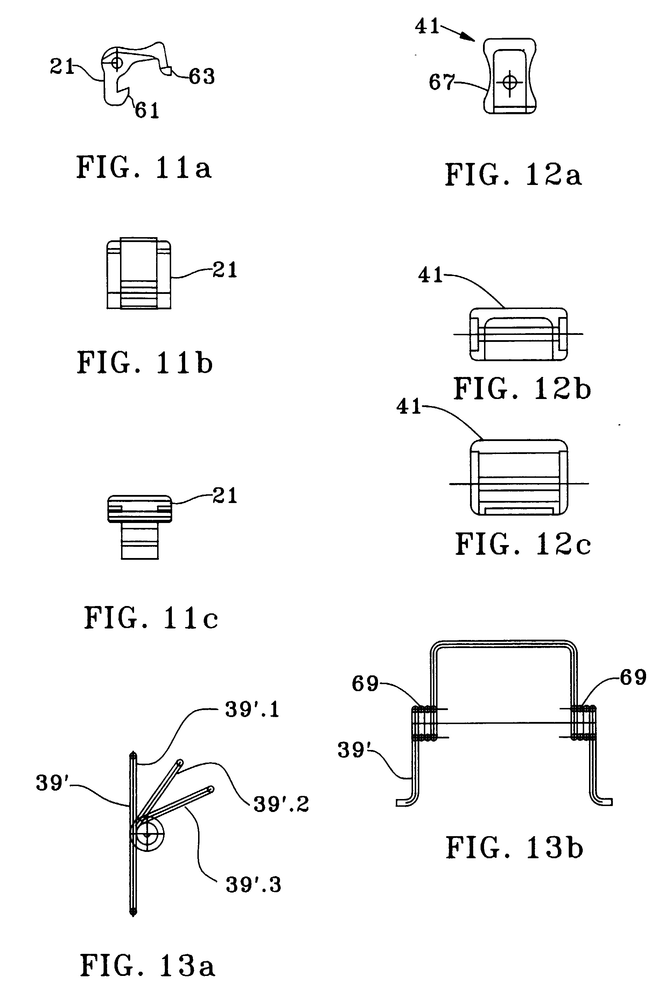

Nous allons maintenant décrire un exemple perfectionné de réalisation du dispositif selon la présente invention illustré sur les figures 4 à 13. Le dispositif comporte une plaque 43, illustrée sur la figure 5, solidarisée, par exemple, par des vis avec la face avant d'un châssis électronique 3. Avantageusement, la plaque 43 se termine dans sa partie supérieure par une languette 44 formant un retour à angle droit dirigée vers le module électronique. Avantageusement, la languette 44 prend appui sur le rail en U 5 supérieur de manière à améliorer le guidage en translation horizontale lors de l'insertion du module électronique ainsi que la tenue aux vibrations de l'ensemble. En variante, la languette 44 peut être remplacée et/ou complétée par un dispositif d'assemblage, par exemple du type comportant un axe et un alésage de formes complémentaires solidarisés avec le bâti et avec le module électronique respectivement. Deux chapes 45 (dont un exemple est illustré sur la figure 9) fixées sur la plaque 43 soutiennent l'axe 13 de rotation de la pièce 11 qui comporte notamment le levier 17 formé par deux branches 29 (illustrées sur la figure 6) solidarisées avec un crochet 15 illustré sur la figure 7. Chaque branche 29 comporte une première ouverture 47 de réception de l'axe de rotation du taquet 21 illustré sur la figure 11, une deuxième ouverture 49 de réception de l'extrémité du ressort de rappel 39' illustré sur la figure 13 et une troisième ouverture 51 de réception d'un élément de fixation d'un bouton de commande 41 illustré sur la figure 12. Le crochet 15 comporte une plaque 53 de fixation sur le levier 17 et, à l'opposé, une encoche 55 de réception de la tige 7. Le crochet de verrouillage 19 illustré sur la figure 10 comporte une paroi arrondie 57 assurant le basculement du taquet 21 et une surface plane inclinée 59 de retenue du taquet. Le taquet 21, vu de côté, a une forme générale en U dont une première branche est terminée par un élément de retenue 61 susceptible de prendre appui sur la surface de retenue 59 du crochet de verrouillage 19, et dont la seconde branche est terminée par une butée 63 sur laquelle prend appui le bouton 41, de manière à assurer le basculement du taquet 21 lors du déverrouillage du dispositif selon la présente invention. En variante non illustrée, le déverrouillage est assuré par un appui direct sur la face avant 22 du taquet 21.

Le bouton 41 s'étend sur toute la largeur du levier 17 et a, avantageusement, une forme ergonomique comportant une face supérieure 65 sur laquelle l'opérateur appuie pour assurer le déverrouillage du dispositif selon la présente invention, prolongée par une jupe 67. Sur la figure 13, on peut voir un ressort 39' exerçant un couple de rappel sur le taquet 21. Le ressort 39' comporte deux enroulements 69 autour de l'axe de rotation du taquet. Dans la position libre, les branches du ressort sont situées dans un plan, comme illustré en 39'.1. Dans la position minimale d'utilisation, le ressort 39' est précontraint avec une rotation par rapport au plan de 35,68°, comme illustré en 39'.2. Le couple maximal de rappel est exercé dans la position 39'.3 correspondant à un angle de 65,66° par rapport au plan. L'étrier 9 portant la tige 7 illustrée sur la figure 8 comporte un support 71 fixé à la base du bâti 1 et un ressort de rappel 73 exerçant une force de rappel vers l'intérieur du bâti. A l'opposé, l'étrier 9 comporte une fourche portant la tige 7 et comportant une fente 75 de passage du crochet 15 autour de la tige 7.

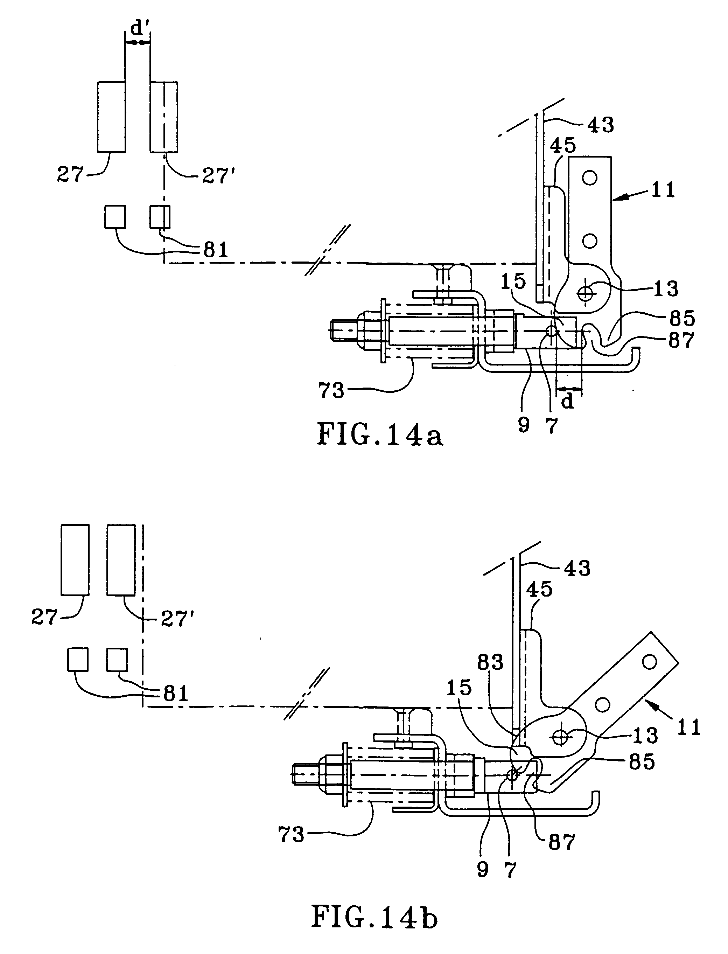

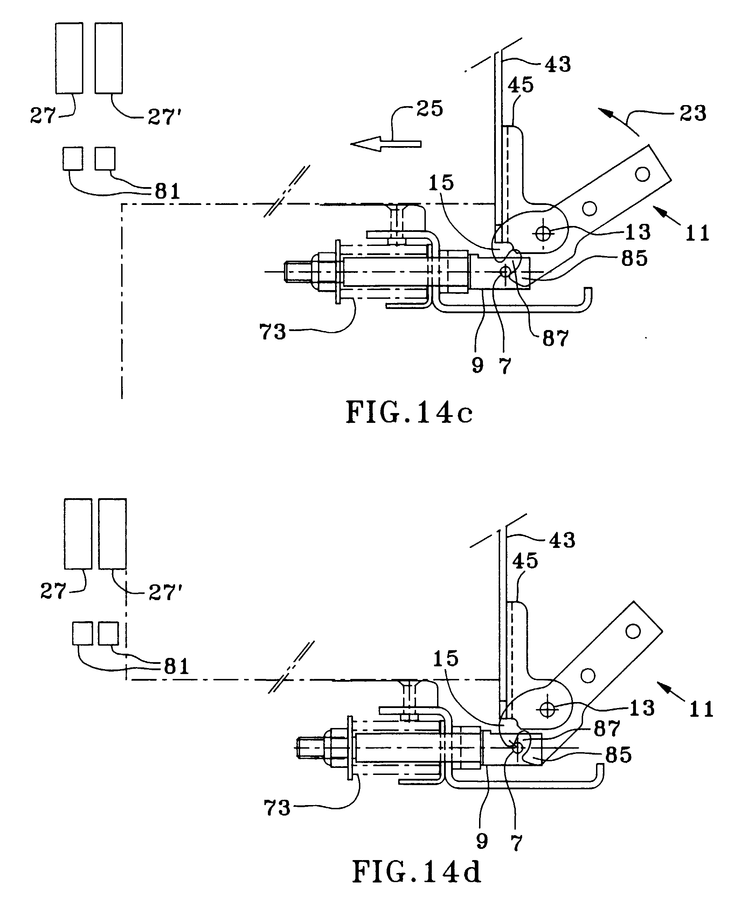

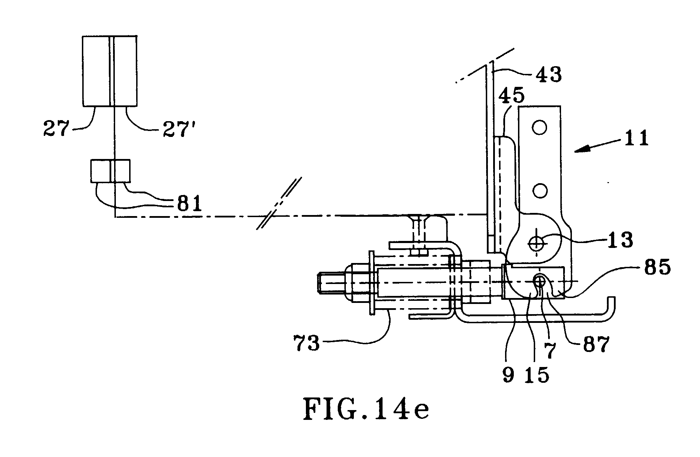

Sur la figure 14, on peut voir l'exemple préféré de réalisation du dispositif selon la présente invention comportant un crochet 15 perfectionné et, avantageusement, des moyens 81 de codage empêchant la connexion d'un module électronique non adapté au logement de réception dans lequel on essaye de l'insérer. Les moyens de codage comportent, par exemple, un premier élément formant clé comprenant un ensemble de tiges disposées au fond du logement de réception du module ou sur la face arrière de ce module électronique à insérer et un second élément formant serrure comportant un ensemble d'alésages complémentaires desdites tiges disposées sur la face arrière du module électronique à insérer ou au fond du logement de réception du module électronique. La disposition des tiges et des alésages est propre à chaque ensemble clé-serrure correspondant à un groupe de modules compatibles avec un groupe d'emplacement de réception de ces modules. Chaque groupe comporte au moins un type de modules et au moins un emplacement de réception. Tous les modules d'un même groupe comportent des connecteurs 27 compatibles entre eux. Avantageusement, les tiges ont une longueur suffisante pour empêcher, dans le cas d'une tentative d'insertion d'un module non compatible avec le logement de réception, le contact entre le connecteur du module et du logement de réception, de manière à éviter tous risques de détérioration des connecteurs, notamment par déformation des plots.

Le crochet 15 comporte sur sa face antérieure dirigé vers les modules électroniques un point 83 de contact avec l'axe 7 dans une position fermée des moyens 11 lors d'une tentative d'insertion incorrecte du module illustré sur la figure 14a. Avantageusement, la distance d entre le point 83 sur la face avant du crochet et le point de la surface d'appui du crochet 15 sur la tige 7 disposé en vis-à-vis est supérieure à la course d' d'insertion et de connexion du connecteur 27 du bâti avec le connecteur 27' du module électronique. Ainsi, si la pièce 11 est dans la position verrouillée sans que le crochet 15 soit accroché sur l'axe 7, le contact électrique au niveau des connecteurs 27, 27' ne peut pas être établi. ll en résulte que, non seulement le mauvais positionnement d'un module électronique dans son logement de réception est immédiatement identifié de par la position mécanique de ce module qui dépasse de son logement, mais en outre un test électrique révèle immédiatement l'absence de connexion. De plus, avantageusement, le bâti comporte un capot (non illustré) dont la fermeture est empêchée par tout module qui ne serait pas complètement enfoncé dans son logement de réception.

Sur la figure 14b, on a illustré une tentative d'insertion d'un module non adapté à son logement de réception. Bien que la pièce 11 comportant le crochet 15 se présente dans la position ouverte, n'empêchant pas l'introduction du module dans son logement, les moyens de codage 81 empêchent l'introduction complète du module dans le logement et notamment l'établissement du contact entre les connecteurs 27 du bâti et 27' du module électronique.

Avantageusement, la pièce 11 montée à rotation comporte, disposée en vis-à-vis de la surface d'appui du crochet 15 sur la tige 7, un talon arrière 85 définissant avec ladite surface d'appui du crochet 15 une rainure 87 de réception et de guidage de la tige 7. La rainure 87 a, avantageusement, une largeur sensiblement égale ou légèrement supérieure au diamètre de la tige 7. Avantageusement, comme illustré sur la figure 14c, lorsque la pièce 11 est dans une position ouverte, par exemple lorsque l'axe de la pièce 11 est incliné de 33° par rapport à l'axe de l'étrier 9, le talon 85 empêche l'établissement du contact électrique au niveau des connecteurs 27 du bâti et 27' du module électronique avant verrouillage mécanique du module dans son logement de réception à l'aide de la pièce 11 et de la tige 7. En effet, même en l'absence des moyens de codage 81 ou de mise en oeuvre des moyens de codage 81 complémentaires au niveau de l'emplacement de réception et du module, le talon 85 empêche le glissement du module selon la flèche 25 antérieurement à la rotation de la pièce 11 selon la flèche 23.

Sur la figure 14d, on peut voir l'exemple préféré de réalisation du dispositif selon la présente invention en cours de montage correct dans son logement de réception au moment de l'établissement du contact électrique entre le connecteur 27 du bâti et le connecteur 27' du module électronique (les plots de connecteur ne sont pas représentés sur la figure). Dans l'exemple non limitatif de la figure 14d, l'axe de la pièce 11 forme un angle de 49,5° par rapport à l'axe de l'étrier 9 lors de l'établissement du contact entre les connecteurs 27 et 27'.

Sur la figure 14e, on peut voir l'exemple préféré du dispositif selon la présente invention correctement verrouillé dans son logement de réception, l'axe de la pièce 11 étant orthogonale à l'axe de l'étrier 9.

Les diverses pièces du dispositif selon la présente invention peuvent être réalisées en tous matériaux présentant une tenue mécanique désirée. Avantageusement, on choisit des matériaux ayant une faible densité volumique et/ou une très bonne résistance mécanique. On peut par exemple réaliser la tige 7 et la pièce 11 en acier haute résistance, en acier inoxydable, en matière plastique, éventuellement renforcé par des fibres, ou en alliage léger et, notamment, en aluminium, alliage d'aluminium ou alliage de magnésium.

Il est bien entendu que la mise en oeuvre du dispositif selon la présente invention pour assurer la connexion d'autres types de modules électriques ou électroniques, notamment des cartes ou des boîtiers divers, ne sort pas du cadre de la présente invention.

La présente invention s'applique notamment à l'industrie informatique et électronique.

La présente invention s'applique principalement à la réalisation d'équipements électroniques et informatiques fonctionnant en temps réel pour environnement sévère.

## Revendications

1. Dispositif de connexion et de solidarisation d'un premier élément sur un second élément, l'un des éléments étant un module (3) électrique ou électronique, l'autre élément étant un dispositif de réception (1) du module électrique ou électronique (3), le dispositif comportant un connecteur à insertion par translation relative des deux éléments, caractérisé en ce qu'il comporte :
a) solidarisés avec le premier élément, des moyens d'ancrage (7, 9 ) ;
b) solidarisés avec le second élément (3), des moyens (11, 15, 17) d'accrochage sur les moyens d'ancrage (7) comprenant un levier (17) dont la rotation après accrochage des moyens d'accrochage (15) sur les moyens d'ancrage (7) assure le positionnement et la translation du second élément par rapport au premier élément, avec insertion du connecteur, établissement des connexions électriques ainsi que la solidarisation des deux éléments.

2. Dispositif selon la revendication 1, caractérisé en ce que le premier élément est un bâti (1) et en ce que le second élément est un châssis électrique et/ou électronique (3).

3. Dispositif selon la revendication 1 ou 2, caractérisé en ce que les moyens d'ancrage (7, 9) sont disposés sur le premier élément de manière à empêcher l'accrochage des moyens d'accrochage (11, 15) sur les moyens d'ancrage (7, 9) dans le cas où la position relative desdits premiers et seconds éléments ne permet pas de garantir lors de la rotation du levier (17) une solidarisation et une connexion correctes et sûres.

4. Dispositif selon l'une quelconque des revendications précédentes, caractérisé en ce qu'il comporte des moyens (19, 21) de verrouillage desdits premiers et seconds éléments dans la condition connectée comprenant des moyens pour empêcher la rotation non désirée du levier (17).

5. Dispositif selon la revendication 4, caractérisé en ce que les moyens de verrouillage comportent un taquet (21) solidarisé avec le levier (17) et un crochet de verrouillage (19) solidarisé avec le premier élément, et en ce que, en fin de course de connexion, le taquet (21) s'accroche automatiquement sur le crochet (19).

6. Dispositif selon la revendication 5, caractérisé en ce qu'il comporte un ressort de rappel (39, 39') du taquet (21) vers la condition accrochée sur le crochet de verrouillage (19) ainsi qu'un bouton (41) de commande monté en translation sur le levier (17), prenant appui sur le taquet (21), la translation du bouton entraînant le taquet (21), assurant sa libération et par suite le déverrouillage du dispositif.

7. Dispositif selon l'une quelconque des revendications précédentes, caractérisé en ce que la distance entre un axe de rotation (13) du levier (17) et une extrémité de manoeuvre de ce levier (17) est grande par rapport à la distance entre la surface d'appui des moyens d'accrochage (15) sur les moyens d'ancrage (7) et ledit axe de rotation (13).

8. Dispositif selon l'une quelconque des revendications 2 à 7, caractérisé en ce que le levier (17) ménage un accès (31) au centre de la face avant d'un châssis électronique (3).

9. Dispositif selon l'une quelconque des revendications précédentes, caractérisé en ce que les moyens d'ancrage comportent une tige (7) montée sur une fourchette (9) comportant une fente (75) et en ce que les moyens d'accrochage comportent un crochet (15) passant dans la fente (75) et prenant appui sur la tige (7).

10. Dispositif selon la revendication 9, caractérisé en ce que les moyens d'ancrage comportent un ressort (73) exerçant sur la fourchette (9) une force de rappel vers le premier élément.

11. Dispositif selon l'une quelconque des revendications précédentes, caractérisé en ce que la distance d entre un point (83) situé sur la face des moyens d'accrochage (11, 15) dirigée, en position d'insertion, vers l'intérieur du logement et le point de la surface d'appui des moyens d'accrochage (11, 15) sur les moyens d'ancrage (7) disposés en vis-à-vis, est supérieure à la course d' d'insertion et de connexion du connecteur (27) du bâti avec le connecteur (27') du module électronique.

12. Dispositif selon l'une quelconque des revendications précédentes, caractérisé en ce que les moyens d'accrochage (15) comportent un talon arrière (85) définissant, avec la surface d'appui des moyens d'accrochage (15), une rainure (87) de réception des moyens d'ancrage (7).

13. Dispositif selon l'une quelconque des revendications précédentes, caractérisé en ce qu'il comporte des moyens de codage (81) adaptés sur les modules électroniques à insérer et sur les logements de réception des modules électroniques correspondants, propres à chaque ensemble module électronique à insérer -logement de réception susceptible de les recevoir.
